(19) Europäisches Patentamt

European Patent Office

Office européen des brevets

(11) **EP 1 624 095 A2**

(12) **EUROPEAN PATENT APPLICATION**

(43) Date of publication:
08.02.2006 Bulletin 2006/06

(51) Int Cl.:
*C30B 29/40* (2006.01)   *C30B 25/02* (2006.01)

(21) Application number: 05016895.4

(22) Date of filing: 03.08.2005

(84) Designated Contracting States:
AT BE BG CH CY CZ DE DK EE ES FI FR GB GR
HU IE IS IT LI LT LU LV MC NL PL PT RO SE SI
SK TR
Designated Extension States:
AL BA HR MK YU

(30) Priority: 04.08.2004 JP 2004228032

(71) Applicant: Sumitomo Electric Industries, Ltd.
Osaka-shi, Osaka 541-0041 (JP)

(72) Inventors:
• **Fujiwara, Shinsuke**
**1-1-1, Koyakita**
**Itami-shi**
**Hyogo (JP)**
• **Nakahata, Seiji**
**1-1-1, Koyakita**
**Itami-shi**
**Hyogo (JP)**

(74) Representative: **Grünecker, Kinkeldey,**
**Stockmair & Schwanhäusser**
**Anwaltssozietät**
**Maximilianstrasse 58**
**80538 München (DE)**

(54) **Nitride semiconductor single-crystal substrate and method of its synthesis**

(57) Fracture toughness of AlGaN single-crystal substrate is improved and its absorption coefficient reduced. A nitride semiconductor single-crystal substrate has a composition represented by the formula $Al_xGa_{1-x}N$ ($0 \leq x \leq 1$), and is characterized by having a fracture toughness of $(1.2-0.7x)$ MPa•m$^{1/2}$ or greater and a surface area of 20 cm$^2$, or, if the substrate has a composition represented by the formula $Al_xGa_{1-x}N$ ($0.5 \leq x \leq 1$), by having an absorption coefficient of 50 cm$^{-1}$ or less in a 350 to 780 nm total wavelength range.

FIG. 1

EP 1 624 095 A2

**Description**

BACKGROUND OF THE INVENTION

Field of the Invention

The present invention relates to nitride semiconductor single crystals that can be used as substrates of various electronic devices, and more particularly to enhancing of fracture toughness and light transmittance of nitride semiconductor single-crystal substrates.

Description of the Background Art

Nitride single-crystal wafers, when used as substrates for semiconductor electronic devices, must as a matter of course be impervious to cracking during the process of manufacturing the semiconductor electronic devices. The reason is that a nitride semiconductor single-crystal wafer that has cracked in the course of a process cannot be put through subsequent processing, meaning that the wafer goes to waste.

In addition to silicon single-crystal wafers, wafers of single-crystal nitride semiconductors have been utilized in recent years as substrates to produce various electronic devices. Among such nitride semiconductor single-crystal wafers, a hexagonal $Al_xGa_{1-x}N$ ($0 < x \leq 1$) semiconductor wafer is a preferable candidate material for manufacturing various electronic devices. It should be noted that in the present specification, "$Al_xGa_{1-x}N$ ($0 < x \leq 1$) semiconductor" will also be referred to as "AlGaN semiconductor" for short.

As noted in the *Japanese Journal of Applied Physics,* Vol. 40, 2001, pp. L426—L427, AlGaN single crystal has a lower fracture toughness than silicon single crystal and therefore tends to be cracking-prone. In particular, AlN substrates are liable to crack during handling since they have a low fracture toughness, on the order of a fraction of that of SiC substrates and sapphire substrates.

Nitride semiconductor single-crystal wafers are often used for producing light-emitting elements, especially for substrates of nitride semiconductor light-emitting elements that can emit light of short wavelengths. In these applications, light of short wavelengths readily excites electrons within the semiconductor substrate, meaning that the light is readily absorbed by the semiconductor substrate. Such absorption of short-wavelength light in a nitride semiconductor substrate ends up degrading the efficiency with which light is extracted externally from the light-emitting element. For that reason, it is desired that the nitride semiconductor single-crystal substrate utilized for manufacturing a light-emitting element have as small an absorption coefficient as possible with respect to light of short wavelengths.

The *Journal ofApplied Physics*, vol. 44, 1973, pp. 292-296 reports that an epitaxially-grown AlN film having a relatively small absorption coefficient from the visible region to the ultraviolet region can be grown by HVPE (hydride vapor phase epitaxy). The AlN film according to this reference, however, cannot be deemed to have a sufficiently small absorption coefficient in short wavelength regions, especially the ultraviolet region. Accordingly, even given that an AlN layer is grown thicker by HVPE for use as a nitride semiconductor single-crystal substrate, there is a need for further reduction in the AlN substrate's absorption coefficient in short wavelength regions.

Nitride semiconductor single-crystal wafers, as described above, have been utilized for substrates of various electronic devices. In particular, the demand for AlGaN single-crystal substrates has increasingly grown in recent years. AlGaN single crystal wafers are, however, susceptible to cracking, which can be a factor detrimental to electronic device productivity. Therefore, a need has been felt in the art to improve the fracture toughness of AlGaN single crystal wafers themselves.

Nitride semiconductor single-crystal wafers have often been used as substrates for short-wavelength light-emitting elements in recent years. In these implementations, the nitride semiconductor single-crystal substrate absorbing shorter wavelength light leads to compromised light extraction efficiency for short-wavelength light-emitting elements. For this reason, a need has been felt in the art to reduce the absorption coefficient of AlGaN single crystal substrates themselves.

SUMMARY OF THE INVENTION

In view of the foregoing circumstances, an object of the present invention is to improve the fracture toughness of AlGaN single-crystal substrates. Another object of the present invention is to reduce the absorption coefficient of AlGaN single-crystal substrates.

A nitride semiconductor single-crystal substrate according to the present invention has a composition represented by the formula $Al_xGa_{1-x}N$ ($0 \leq x \leq 1$), and is characterized by by having a fracture toughness of (1.2-0.7x) MPa • $m^{1/2}$ or greater, and a surface area of 20 $cm^2$ or more.

A nitride semiconductor single-crystal substrate according to the present invention may have a composition represented by the formula $Al_xGa_{1-x}N$ ($0.5 \leq x \leq 1$), and be characterized by having an absorption coefficient of 50 cm$^{-1}$ or less over the entire wavelength range of from 350 nm to 780 nm.

Such a nitride semiconductor single-crystal substrate may have a total impurity density of $1 \times 10^{17}$ cm$^{-3}$ or less.

A nitride semiconductor single-crystal substrate as described above advantageously can be synthesized by HVPE. It is preferable that the inner wall of the crystal growing furnace used for the HVPE, in the region that the source gases contact at a temperature of 800°C or greater, be formed of pBN (pyrolytic boron nitride); be formed of a sintered material of any one of a nitride, a carbide, or an oxide; or be formed of a component superficially coated with any one of pBN, a nitride, a carbide, or an oxide.

BRIEF DESCRIPTION OF THE DRAWINGS

Fig. 1 illustrates single-crystal growing equipment that may be used for synthesizing by HVPE an AlGaN single-crystal substrate according to the present invention; and

Fig. 2 is a graph showing the dependency of absorption coefficient on wavelength in AlN single crystal substrate according to the present invention.

DETAILED DESCRIPTION OF THE INVENTION

As already discussed above, there is a need for AlGaN single crystal substrates to be impervious to cracking if the substrates are intended to be used for manufacturing various semiconductor electronic devices. The physical parameter that defines the imperviousness is fracture toughness. Herein, the present inventors have found that an increase in impurities in an AlGaN single-crystal substrate correspondingly reduces the fracture toughness, making the substrate crack more easily. That is, it has been found that reducing the impurity density is important for improving the toughness of the AlGaN single-crystal substrate.

Based on this finding, the present inventors grew AlN single crystals and GaN single crystals, eliminating sources of impurities to the utmost. For growing the AlN crystals, the seed crystal substrate used was a 51-mm diameter AlN single crystal having its principal surface in the (0001) plane, and the source gases were $HN_3$ and $AlCl_3$ or AlCl. On the other hand, for growing the GaN crystals, the seed crystal substrate used was a (0001) GaN single crystal 51 mm in diameter, and the source gases were GaCl and $HN_3$.

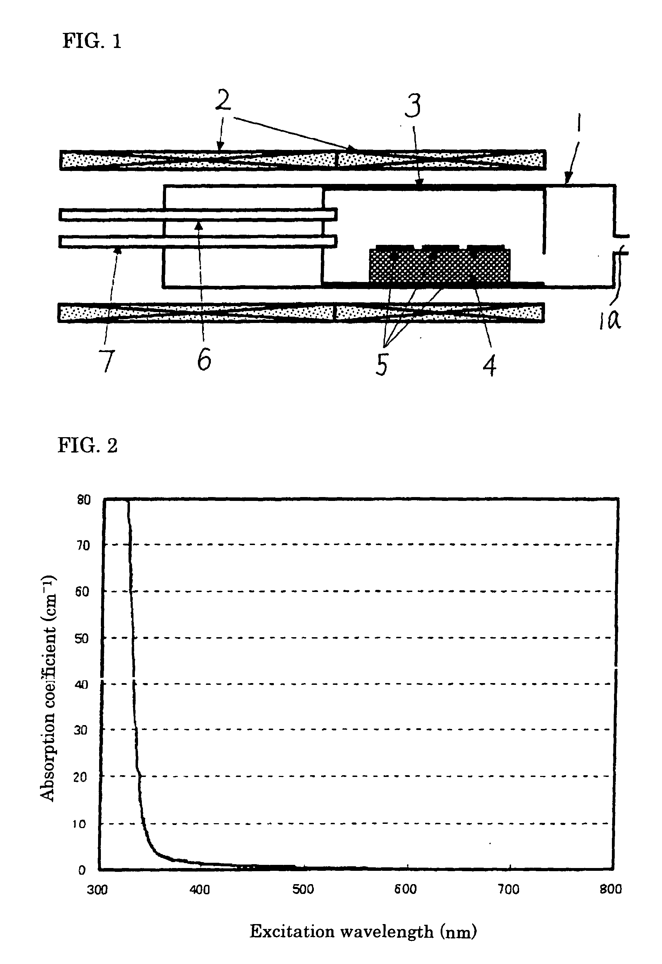

Fig. 1 is a schematic cross-sectional diagram of a single-crystal growing furnace utilized according to the present invention in the HVPE synthesis of AlN single crystals and GaN single crystals. As represented in the figure, a reactor tube 1 of quartz glass has an exhaust port 1a, around which a heater 2 is arranged.

The quartz glass can become a source of silicon and oxygen contamination at high temperatures (which is particularly noticeable at a temperature of 800°C or higher). Likewise, even if a graphite liner is arranged in the reactor tube 1 in the region where the temperature becomes high, the liner can become a source of carbon contamination at high temperatures.

Thus, to address this contamination issue a liner 3 of pBN was arranged within the reactor tube 1 in the region where the temperature goes to 800°C or higher. The material for the liner 3 is not limited to pBN; the liner may be formed of nitride, carbide, or oxide sinters (in which preferably a binder is not used), or it may be formed of a component coated with a nitride, carbide, or oxide.

Within the liner 3, a seed crystal substrate 5 of either AlN or GaN was placed on top of a pBN stage 4. A Group III precursor gas ($AlCl_3$, AlCl, or GaCl) was introduced into the liner 3 through a first gas introduction tube 6, while $NH_3$ gas was introduced through a second gas introducing tube 7.

The carrier gas used was high-purity $H_2$, $N_2$, Ar, or a gas mixture thereof. The relative proportions supplied of the Group III element precursor gas and the $NH_3$ gas were set to be within the range of from 1 : 10 to 1 : 1000. The substrate temperature was set to be within the range of from 900°C to 1100°C. The synthesizing conditions were controlled so that the growth rate would be 10 to 50 $\mu$m/h, whereby a single crystal of AlN or GaN was grown on the substrate to a thickness of 5 mm. It should be noted that an AlGaN hybrid single crystal may be developed by introducing an Al source gas and a Ga source gas into the liner 3 at the same time.

The GaN crystal and the AlN crystal thus obtained were sliced into AlN substrates and GaN substrates, each having a thickness of 0.5 mm and a diameter of 51 mm, and with the principal face in the (0001) plane. Both sides of the substrates were polished to a mirrorlike finish and thereafter etched, yielding AlN substrates and GaN substrates of 0.4 mm thickness and being mirror-smooth on both sides.

The AlN substrates and GaN substrates were observed by SIMS (secondary ion mass spectroscopy) analysis to measure their impurity densities. In both substrates, the most prevalent impurity was oxygen, the density of which measured $5 \times 10^{16}$ cm$^{-3}$ or less, against a total impurity density of $1 \times 10^{17}$ cm$^{-3}$ or less.

Furthermore, fracture toughness values for the AlN substrates and GaN substrates were measured. Based on the length of cracks formed on the substrates under an applied indentation load according to a Vickers hardness test using a pyramidal diamond indenter, fracture toughness was evaluated using the following equations (1) and (2).

$$K_C = \xi (E/H_v)^{1/2} (P/c^{3/2}) \qquad (1)$$

$$H_v = P/(2a^{3/2}) \qquad (2)$$

In the above equations, $K_c$ is the fracture toughness, $H_v$ is the Vickers hardness, $E$ is Young's modulus, $\xi$ is a calibration constant, $P$ is the indenter load (0.5 to 5 $N$), $2a$ is the diagonal lengths of the impression, and $c$ is the radial crack length.

As a result of evaluation based on the foregoing equations (1) and (2), it was found that the fracture toughness of the AlN substrate was 0.5 MPa • m$^{1/2}$ and the fracture toughness of the GaN substrate was 1.2 MPa • m$^{1/2}$.

For comparison, with a GaN substrate into which, without the liner 3 having been used, on the order of 1 $\times$ 10$^{18}$ cm$^{-3}$ impurities including oxygen and carbon are intermixed, the fracture toughness is on the order of 1.0 MPa • m$^{1/2}$; thus it was discovered that by heightening the purity the fracture toughness is improved. In this way the inventors succeeded in manufacturing AlGaN substrates exhibiting superior fracture toughness.

A circumferential grinding operation was carried out on obtained GaN substrates (rounding them to a diameter of 2 inches), wherein with low-purity GaN substrates, in which the facture toughness was low, cracking occurred frequently, such that the yield rate was 20% or so. On the other hand, with GaN substrates whose facture toughness had been enhanced by heightening the purity, the yield rate was improved to up to 80%. It should be noted that since the more substrates are enlarged in diametric span, the more serious the problem of substrate breakage will be, with smaller substrates of less than some 20 cm$^2$, improvement in fracture toughness is not as strongly desired.

Among nitride semiconductors, AlN and AlGaN (with a high Al concentration), having wide energy bandgaps, are promising as light-emitting materials for the ultraviolet region. More specifically, production of ultraviolet light-emitting elements by forming a pn junction with a similar Group III element nitride on a substrate of AlN or AlGaN has been attempted. In such attempts, if the substrate absorbs the ultraviolet generated in the light-emitting element, the efficiency with which UV rays are extracted from the light-emitting element to the exterior ends up diminishing.

Basically, because light with lower energy than the bandgap of a substrate passes through the substrate, it is believed that A1N or AlGaN (with a sufficiently large A1 composition) should be utilized. A1N and AlGaN, however, are known to absorb light with considerably lower energy than the bandgap. Although the causative source of the absorption is not yet clear, it is thought to be absorption due to impurities.

The absorption coefficient of a high-purity AlN substrate obtained according to the present invention was measured in order to learn the substrate's optical properties. The absorption coefficient was calculated from transmittance and reflectivity measurements. The absorption coefficient within the substrate was assumed to be constant irrespective of the depth in the substrate and was calculated taking multiple reflection also into consideration.

Fig. 2 plots the AlN substrate absorption coefficient measurements thus obtained. In the Fig. 2 graph, the horizontal axis represents of excitation-beam wavelength, with a range of from 300 nm to 800 nm being set forth. The vertical axis represents absorption coefficient in a range of from 0 cm$^{-1}$ to 80 cm$^{-1}$.

Fig. 2 demonstrates that with a high-purity AlN substrate according to the present invention, in the wavelength region below 350 nm the absorption coefficient started to increase abruptly as the wavelength wass reduced, but that in the wavelength region above 350 nm, the absorption coefficient was 50 cm$^{-1}$ or less. Herein, an absorption coefficient of 50 cm$^{-1}$ or less means that the amount of light transmitted attenuates to 1/e at a transmission distance of (1/50) cm = 200 $\mu$m. Because the typical substrate thickness of light-emitting elements such as LEDs (light emitting diodes) is about 200 $\mu$m, it is preferable that a light-emitting element substrate have an absorption coefficient of 50 cm$^{-1}$ or less.

It should be understood that the slicing of wafers for substrates from the obtained AlGaN single crystal can be carried out so that the principal face of the substrate being sliced is not the (0001) plane, but is instead the $(11\bar{2}0)$ plane, the $(10\bar{1}2)$ plane, the $(10\bar{1}0)$ plane, the $(10\bar{1}1)$ plane, or a plane inclined from these planes in a direction of choice. Likewise, the planar orientation of the seed crystal substrate can be preestablished to be in a chosen planar orientation. From a productivity perspective, however, using seed crystal substrates whose principal-face orientation is the same as the principal face orientation of the substrates as cut is to be preferred.

Moreover, although the foregoing embodiment used 51-mm diameter seed crystal substrates, a seed crystal substrate of larger diametric span may of course be used if available. The thickness of the single crystal to be grown by HVPE is not limited to 5 mm as in the foregoing example, and the AlN crystal may of course be grown thicker.

In the manufacture of light-emitting elements such as light-emitting diodes and laser diodes, of electronic devices such as rectifiers, bipolar transistors, field effect transistors, and HEMTs (high electron mobility transistors), of semiconductor sensors such as temperature sensors, pressure sensors, radiation sensors, and visible/ultraviolet light sensors, and of SAW (surface acoustic wave) devices, utilizing high-purity AlGaN substrates obtained according to the present invention reduces the likelihood of breakage in the course of the manufacturing operations, enabling improved production efficiency

The present invention enables nitride semiconductor single-crystal substrates to have improved fracture toughness, making it possible to prevent wafer breakage and increase productivity in the process of manufacturing semiconductor electronic devices utilizing the substrates.

Moreover, since the present invention also enables nitride semiconductor single-crystal substrates to have improved light transmittance, utilizing the substrates enables semiconductor light-emitting elements of enhanced light extraction efficiency to be made available.

**Claims**

1. A nitride semiconductor single-crystal substrate having a composition represented by the formula $Al_xGa_{1-x}N$ ($0 \leq x \leq 1$), **characterized by** having a fracture toughness of $(1.2-0.7x)$ MPa $\cdot$ m$^{1/2}$ or greater, and a surface area of 20 cm$^2$ or more.

2. A nitride semiconductor single-crystal substrate having a composition represented by the formula $Al_xGa_{1-x}N$ ($0.5 \leq$ *x $\leq 1$), **characterized by** having an absorption coefficient of 50 cm$^{-1}$ or less over the entire wavelength range of from 350 nm to 780 nm.

3. The nitride semiconductor single-crystal substrate as set forth in claim 1 or 2, **characterized by** having a total impurity density of $1 \times 10^{17}$ cm$^{-3}$ or less.

4. A method of synthesizing a nitride semiconductor single-crystal substrate as set forth in any one of claims 1 through 3, the nitride semiconductor single-crystal substrate synthesizing method **characterized in that** said substrate is synthesized by HVPE

5. The nitride semiconductor single-crystal substrate synthesizing method as set forth in claim 4, **characterized in that** in a crystal growing furnace used for said HVPE, an inner-wall region that source gases contact at a temperature of 800°C or greater is formed of pBN, is formed of a sintered material of any one of a nitride, a carbide, or an oxide, or is formed of a component superficially coated with any one of pBN, a nitride, a carbide, or an oxide.

FIG. 1

FIG. 2

Excitation wavelength (nm)